(19) Europäisches Patentamt
European Patent Office
Office européen des brevets

(11) Publication number: **0 152 475**
**B1**

# (12) EUROPEAN PATENT SPECIFICATION

(45) Date of publication of the patent specification: **25.11.87**

(51) Int. Cl.⁴: **G 03 C 1/68,** G 03 C 5/00

(21) Application number: **84903263.6**

(22) Date of filling: **22.08.84**

(86) International application number: **PCT/US 84/01340**

(87) International publication number: **WO 85/01127 (14.03.85 Gazette 85/07)**

## (54) PHOTOPOLYMERIZABLE COMPOSITIONS.

(30) Priority: **24.08.83 US 526156**
**20.08.84 US 641993**
**20.08.84 US 641994**

(43) Date of publication of application: **28.08.85 Bulletin 85/35**

(45) Publication of the grant of the patent: **25.11.87 Bulletin 87/48**

(84) Designated Contracting States: **CH DE FR GB LI NL SE**

(56) References cited:
**US-A-3 445 229**
**US-A-4 173 474**

(73) Proprietor: **POLAROID CORPORATION, 549 Technology Square, Cambridge, Massachusetts 02139 (US)**

(72) Inventor: **FIELDING, Herbert, F., 48 Butters Roe, Wilmington, MA 01887 (US)**
Inventor: **INGWALL, Richard, T., 115 Dartmouth Street, Newton, MA 02165 (US)**

(74) Representative: **Urbanus, Henricus Maria, Ir., c/o Vereenigde Octrooibureaux Nieuwe Parklaan 107, NL- 2587 BP 's- Gravenhage (NL)**

**EP 0 152 475 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convension).

LIBER, STOCKHOLM 1987

**Description**

The invention is concerned with photography and, more particularly, with photopolymerizable materials comprising an ethylenic unsaturated monomer, a dye sensitizer, and a photoinitiator. The photopolymerizable materials provided by this invention are particularly adapted for use in forming holograms.

Photopolymerization is a process which leads to the formation of a polymer from monomeric molecules. Many photopolymerizable materials are known in the art, and have been used to form resist and other types of images.

A good review of photopolymerization processes appears in Chapter X of Imaging Systems, Jacobson and Jacobson, John Wiley & Sons, N.Y., N.Y., pp. 181-222 (1976). Dye-sensitized photopolymerization systems are discussed in some detail; see, for example, pp. 184, 195-197, and 214-216. A wide variety of ethylenic unsaturated monomers are noted as useful in such systems. The use of methylene blue as a dye sensitizer in combination with sodium p-toluene sulfinate as a polymerization initiator is noted as a particularly useful photopolymerization initiation system with barium diacrylate and actylamide, and such a photopolymerizable composition also is noted as useful as a holographic recording material. U.S. Patent No. 3,694,218 issued to Margerum et al on September 26, 1972 describes the formation of holograms using a similar photopolymerization system comprising, e.g., barium diacrylate, lead diacrylate, acrylamide, methylene blue, p-toluenesulfinic acid sodium salt and 4-nitrophenylacetic acid sodium salt.

Other polymerization initiators disclosed in said U.S. Patent No. 3,694,218 include triorgano phosphines, triorgano arsines and other organic sulfinic compounds. Similar disclosures of polymerization initiators appear in U.S. Patents No. 3,573,922 issued April 6, 1971 and 3,649,495 issued March 14, 1972, both in the name of Rust.

Photopolymerization systems of the type described in the aforementioned Margerum and Rust patents are liquids, and are used by being placed between glass slides spaced apart to form a thin cell. The addition of a film-forming thickener to increase viscosity or to form a film has been proposed in U.S. Patent No. 3,594,204 issued August 3, 1971 to Rust; examples of proposed polymeric thickeners include gelatin, polyvinyl alcohol, polyvinylpyrrolidone and cellulosic compounds. A similar disclosure appears in U.S. patent No. 3,531,281 issued September 29, 1970 to Rust, wherein the addition of polyvinyl pyrrolidone is said to be for the purpose of adding viscosity to the solution so that it would form a more satisfactory film on glass. U.S. Patent No. 3,658,526 issued April 25, 1972 to Haugh discloses the addition of a varity of polymers to form photopolymerizable films using monomers having a boiling point above 100° C.

The formation of phase holograms by photopolymerization using barium diacrylate in combination with methylene blue and p-toluene sulfinic acid is discussed at some length by Jenney in an article "Holographic Recording with Photopolymers", Journal Optical Society of America, Vol. 60, pp. 1155-1161, September 1970.

Margerum et al have reported on a number of "catalysts" or polymerization initiators used in combination with methylene blue and acrylamide in a paper "Studies on the Mechanism of Dye-sensitized photopolymerization Initiation", Polymer Preprints for the 160th American Chemical Society Meeting, Chicaco, Illinois 15 September 1970, pp. 634-644. In some instances, a mixture of acrylamide and barium diacrylate was used. Margerum et al concluded that the sulfinate ions were far superior to such other catalysts as triethanolamine and ethylenediamine tetraacetic acid (EDTA). Sugawara et al (Applied Optics, Vol. 14, Feb., 1975; pp. 378-382) have reported on the use of acetylacetone and triethanolamine as initiators with acrylamide and methylene blue.

It has been recognized that such photopolymerization systems generally have limited shelf lives - sometimes only a few hours - even though the monomers and photocatalyst systems individually have long shelf lives; note Jenney, supra, p. 1155 and Sugawara et al, supra, pp. 378 and 382. For this reason, the art has taught that the components should be mixed and coated just prior to use. Indeed, U.S. Patent No. 4,036,647 issued July 19, 1977 to Brault et al proposes a structure in which part of photopolymerizable composition is coated on a support while the remaining components are contained in a liquid stored in a rupturable container or pod. Rupture of the pod and distribution of the liquid between said coated support and a second element forms the photopolymerizable composition in situ immediately prior to use.

U.S. Patent No. 4,173,474 issued November 6, 1979 in the name of Tanaka et al. discloses the formation of holograms by the photopolymerization of a monomer, e.g., barium acrylate, in a carrier polymer, e.g., gelatin, followed by immersion in one or more solvents such as isopropanol. Tanaka et al mention polyethylenimine and polyvinyl pyrrolidone in a long list of alternative polymers suitable for use as the carrier polymer; note col. 3, line 67 to col. 4, line 19. The carrier polymer is selected on the basis of its swellability when contacted by a solvent after photopolymerization; see col. 2, lines 23-25. There is no white light exposure to fix the laser exposed coating. The patent does not disclose or suggest applicants' discovery that branched polyethylenimine is an active participant in dye sensitized photopolymerization of ethylenic unsaturated monomers. Moreover, Tanaka et al neither disclose nor suggest the use or special properties of lithium acrylate as the photopolymerizable monomer.

In acordance with the present invention, novel dye-sensitized photopolymerizable compositions are provided which utilize a branched polyethylenimine as the photoinitiator or polymerization initiator.

In the preferred embodiments of this invention, the photopolymerizable monomer is lithium acrylate and the photopolymerizable composition is coated on a support to provide a photosensitive element exhibiting extended shelf life.

It has been found that a branched polyethylenimine is a highly effective initiator of dye-sensitized

photopolymerization. As used herein, "branched polyethylenimine" is intended to designate polyethylenimines containing tertiary nitrogen atoms (tertiary amine groups). Examples of such branched polyethylenimines are those having the formula:

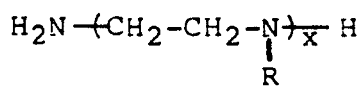

wherein R is

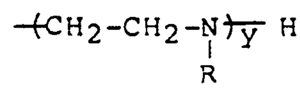

Such branched polyethylenimines have the CAS No. 9002-98-6 and are commerically available from Cordova Chemical Co. of Michigan, North Muskegon, Michigan, under the tradename "Corcat". Branching during polymerization is reported to lead to approximately 30 % primary, 40 % secondary and 30 % tertiary amines.

Derivatized polyethylenimines which contain tertiary nitrogens also are suitable, e.g., hydroxyethylated polyethylenimines such as that commercially available from Dow Chemical Co., Midland, Michigan under the tradename "PEI 600E" and said to have the formula:

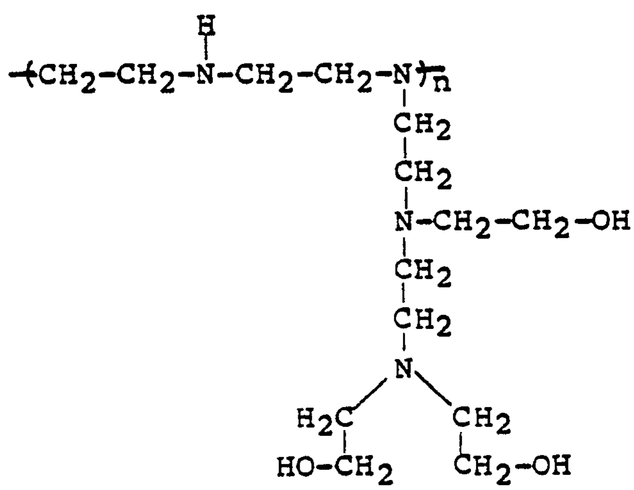

Other useful branched polyethylenimines may be prepared by derivatizing linear or branched polyethylenimine.

Linear polyethylenimine, such as that sold by Dow Chemical Co. and prepared by hydrolyzing polyethyloxazoline, however, has been found ineffective as a photopolymerization initiator.

While applicants do not wish to be bound by any theory, it is believed that light absorption by the dye sensitizer changes it to the excited triplet stage, and the thus excited dye sensitizer extracts a proton from a carbon atom adjacent to a tertiary nitrogen of the branched polyethylenimine to form a free radical which is the active polymerization initiator.

The concentration of tertiary nitrogens provided by the branched polyethylenimine is not critical, provided it is sufficient to obtain the desired rate of polymerization. In general, it is preferred that at least 20 % of the nitrogens be tertiary. Routine experimentation may be used to determine appropriate concentrations for a given system.

A wide variety of ethylenic unsaturated monomers may be used in dye-sensitized photopolymerization systems using a branched polyethylenimine polymerization initiator. The particular monomer will be selected according to the type of image and image properties desired. Anionic monomers such as acrylic acid monovalent salts are preferred, since the polyanion formed by polymerization may complex with the branched polyethylenimine polycation. Sodium acrylate, ammonium acrylate and lithium acrylate are examples of such monomers.

Lithium acrylate is the preferred polymerizable monomer and, indeed, has been found to give unique results (as discussed in detail, infra), even as compared with sodium acrylate, when used in combination with a branched polyethylenimine.

The polymerizable ethylenic unsaturated monomers employed in the practice of this invention may, and normally do (especially as obtained commercially), contain a minor amount of a polymerization inhibitor to prevent spontaneous thermally induced polymerization before polymerization is desired. A preferred inhibitor is p-methoxyphenol, although others well known in the art may be used. The presence of a small amount of

such an inhibitor is not a problem in the practice of this invention.

The dye or photosensitizer is selected to correspond to the wavelength or wavelength range which it is desired to record. Where a hologram is the intended product, the photosensitizer is selected on the basis of the laser which will be employed in making the holographic exposure. In general, images may be recorded over the entire visible wavelength range as well as in the ultraviolet and infrared regions by using a dye sensitizer absorbing at the desired wavelength(s). (It is recognized that dye sensitizers absorbing in the ultraviolet and infrared may exhibit little, if any, visible absorption and therefore may appear to be colorless. The term "dye sensitizer" is intended to include such colorless light absorbers as well as those which are colored.)

A particularly useful dye sensitizer for use in combination with a branched polyethylenimine is methylene blue. Other useful dye sensitizers include erythrosin, eosin Y and riboflavin-5-phosphate. Combinations of dye sensitizers also may be used, particularly dyes which will absorb radiation not efficiently absorbed by methylene blue but which upon absorbing radiation will emit radiation of a wavelength absorbed by methylene blue, thereby activating the methylene blue. The combination of methylene blue and a branched polyethylenimine is preferred, since this combination has been found to give increased light sensitivity permitting shorter exposures. Other useful dye sensitizers may be identified by routine experimentation among the various compounds known in the literature for this purpose. The dye sensitizer concentration may be determined by routine tests as a function of the particular polymerization system components and the desired polymerization rate for the particular application.

The photopolymerizable compositions provided by this invention may be used in the form of solutions or fluids disposed between spaced-apart glass slides. Such techniques are well known in the art, and are described, for example, in the above-noted patents and articles in the names of Rust, Margerum and Jenney. The polymerizable monomer or mixture of monomers preferably is selected to provide a clear solution with the dye sensitizer and the branched polyethylenimine, as such clear compositions yield higher resolution. It will be understood, however, that combinations may be used wherein a monomer or other component is not completely dissolved if the loss of resolution caused by the resultant light scattering is acceptable for the intended use. Certain combinations which provide clear solutions or "fluids" may if coated to form a film give a hazy film due to precipitation or other type of phase change; where high resolution is desired, such photopolymerizable compositions are preferably used in the fluid form.

As noted above, the prefered embodiment of this invention comprises the combination of lithium acrylate, a dye sensitizer, and a branched polyethylenimine, and particularly such a combination together with poly-N-vinyl pyrrolidone. In general, the lithium acrylate will be present in a stoichiometric excess based upon the total nitrogens of the branched polyethylenimine. In the preferred embodiments, lithium acrylate comprises about 50 % by weight of the coated film. If the lithium acrylate is prepared as the monohydrate, it is advantageous to convert it to the anhydrous form prior to forming the coating fluid to minimize the amount of water therein.

The above-noted preferred embodiment using lithium acrylate has been found to permit the formdtion of dry, clear films which have a long shelf life. The resulting film has high sensitivity as a photopolymerizable material, and produces very high resolution volume phase holograms, both transmission and reflection.

As noted above, the use of lithium acrylate in combination with a branched polyethylenimine, especially when poly-N-vinyl pyrrolidone also is present; has been found to give dry, clear films. In contrast, for example, the use of sodium acrylate, potassium acrylate or ammonium acrylate in place of lithium acrylate has been found to give hazy or cloudy films, sometimes tacky, even though the corresponding photopolymerizable solutions have been clear.

The exposure time may be readily determined by routine testing, as is well known in the art, and will vary according to the intensity of the exposing radiation, the distance from the object to the photopolymerizable element, the photosensitizer concentration, and similar factors. These factors may be varied as necessary to change the exposure duration, either shorter or longer, as desired to obtain the optimum combination of exposure duration and light intensity for a given photopolymerizable composition and application. Where the exposure is to a laser to form a volume phase hologram, a subsequent non-imagewise or flood exposure to white light is useful to fix the photopolymerizable layer.

The thickness of the photopolymerizable composition is not particularly critical and may be selected accordingly to the intended use, as is well known in the art. In general, the dry thickness of a coated film will be about 2-10 micrometer, although coatings may be as thick as 25-30 micrometer for certain applications. The support may be rigid, e.g., glass, or flexible, e.g., polyester film base, and preferably is transparent. Furthermore, the support may be flat ot curved.

Coating may be effected by spin coating, slot coating ot curtain coating. Where it is desired to use a flexible support of low birefringence, e.g., surface hydrolyzed cellulose triacetate film base, such a coated film may be laminated to a glass plate with the photopolymerizable coating outermost. Such a construction provides the benefits of continuous coating technology and rigidity during exposure, as well as avoiding exposure of the film base to solvents used in the various processing solutions, particularly where such solvents might adversely affect the flatness or dimensional stability of the film base.

Where desired to facilitate smooth and uniform coating, the coating composition may contain wetting agents or solvents adapted to aid coating. The particular additive may vary depending upon the coating conditions and the support being coated. Lower alcohols such as 2-propanol are useful in certain applications. As examples of wetting agents which have been found useful in coating lithium acrylate photopolymerizable

compositions where it is desired to minimize alcohol content, mention may be made of surfactants such as Fluorad 120 and Corfax 712. (Fluorad 120 is available from 3M Co., St. Paul, Minnesota; Fluorad is a R.T.M.; Corfax 712 is a surfactant based on a low molecular weight polyethenimine attached to a long chain hydrocarbon, and is commercially available from Cordova Chemical Co. of Michigan, North Muskegon, Michigan; it is said to have a molecular weight of 486.)

It is a unique characteristic of the photopolymerizable lithium acrylate compositions of the preferred embodiment of this invention that they are photosensitive only when "moist", and that when "dry" they may be stored for extended periods and rendered photosensitive again simply by humidifying for a short time. Thus, the freshly coated photopolymerizable composition is air dried to remove water and low boiling organic solvents present, e.g., 2-propanol, and prior to use is stored over a desiccant or in a sealed package, preferably light tight, of the type having a moisture barrier to prevent changes in the humidity within the sealed package. Shortly prior to use, the dry photopolymerizable element may be activated by being placed in a humidity chamber (preferably about 51 % R.H.) to equilibrate. The branched polyethylenimine is hygroscopic and will rapidly absorb moisture. The humidified photopolymerizable composition remains a coated film but contains sufficient moisture to provide a "semi-fluid" medium for photopolymerization. This characteristic facilitates the lateral diffusion of monomer within the coating from areas of no exposure to adjacent exposed areas where polymerization is occuring during the image exposure, thereby resulting in a higher concentration of "monomer" units in exposed than unexposed areas. Since photopolymerization gives an increase in the index of refraction, this lateral diffusion or migration and consequent concentration change is effective to increase the delta in index of refraction between exposed and unexposed areas.

After the image and flood exposures, the imaged element may be intensified by treatment with 2-isopropanol. The dried imaged element may then be sealed to a transparent, substantially moisture-impermeable cover such as a microscope glass plate. A suitable adhesive is an alpha-cyanoethyl acrylate type adhesive, such as "Eastman 910" (Eastman is a R.T.M. of Eastman Kodak Co., Rochester, N.Y.). In a preferred embodiment, the imaged element is treated with an alcoholic solution of a zirconium compound, e.g., zirconium acetate, zirconyl nitrate or zirconyl chloride. The resulting cross-linked imaged element is highly resistant to moisture, thus eliminating the need in many instances to seal the imaged element to a moisture-impermeable cover.

In the preferred embodiments of this invention, and particularly in those embodiments concerned with forming a volume hologram, a small quantity of an inert, compatible polymer also is present to give a low viscosity, high solids solution for coating. Poly-N-vinylpyrrolidone is preferred for this use.

It will be understood that the photopolymerizable compositions are prepared, coated and handled prior to use in the absence of light of wavelengths absorbed by the dye sensitizer, e.g., under safelight conditions.

The following examples are given for the purpose of illustration and are not intended to be limiting.

**Example 1**

A photosensitive element was prepared as follows: a premix aqueous solution of polyethylenimine was prepared comprising Corcat P-600 branched polyethylenimine (mol. wt. 40-60,000), 2-propanol, and p-methoxyphenol in water. This solution was mixed with an aqueous solution of poly-N-vinyl pyrrolidone (30 % solids; Plasdone C-15; Plasdone is a R.T.M. of GAF, Inc.), a solution of methylene bisacrylamide in 2-propanol and water, an aqueous methylene blue solution, acrylic acid containing a small amount of p-methoxyphenol polymerization inhibitor, lithium acrylate and water to give a coating solution having the following composition (weight percent):

| | |
|---|---|
| Acrylic acid | 1.48 |
| p-methoxyphenol | 0.00448 |
| Lithium acrylate | 18.8 |
| Water | 64.46 |
| 2-propanol | 1.56 |
| Corcat 600 | 5.06 |
| Methylene bisacrylamide | 0.135 |
| Poly-N-vinyl pyrrolidone | 8.45 |
| Methylene blue | 0.0426 |

The above coating solution was spin coated on 5.08 cm (2 inch) square glass slide covers to a dry thickness of about 5 micrometer. The coated glass slides were air dried and stored over Drierite.

**Example 2**

A coated glass slide prepared as described in Example 1 was prepared for use by incubating at 51 % R.H. for 25 minutes. The coated glass slide was slightly cloudy when removed from the dry box but was clear after the humidity incubation. A transmission hologram suitable for use as a holographic lens was made in a standard laser holographic set-up with lenses in front of the exposure plane so that the object beam (converging to a focal point behind the exposure plane) and the reference beam (diverging) each made a circle having a 4.0 mm diameter at the exposure plane, with the two circles overlapping and covering the same area. The variable beam splitter was adjusted so that the first order intensity of each of the object and reference beams at the exposure plane was 0.8 $mw/cm^2$ with the angle between the beams being 52°. Two laser exposures of 4 and 8 seconds each using a He:Ne laser (633 nm) were made on the coated glass slide, at opposite corners, each through the glass. Without removing it from the exposure plane, the exposed slide was flood exposed for 2 minutes with a reflector-mounted 60 w bulb. The resulting plate was optically clear with information recorded as a modulation of refractive index. A good quality image, closely matching that from the original beam, was obtained when the image was reconstructed by the reference beam using the thus-obtained hologram. A very good quality Airy disk (a diffraction pattern consisting of a bright central disk surrounded by a number of fainter rings) was observed using a horizontally mounted microscope with a 10X eyepiece and a 20X objective. The slide was then washed in 2-propanol at room temperature and then dried by spinning the slide and blowing filtered compressed air on it.

**Example 3**

The procedure described in Example 2 was repeated, with a single 8 second laser exposure. After the 2-propanol wash, the slide was treated with 2-propanol vapors by being held over boiling 2-propanol for one minute. The image was somewhat brighter after the 2-propanol wash and much brighter after the 2-propanol vapor treatment. A heavy cover glass was glued onto the image using an α-cyanoethyl acrylate glue. The diffraction efficiency of the hologram was found to be 47 %.

**Example 4**

A coating mix similar to that described in Example 1 was prepared having the following composition:

| | |
|---|---|
| Acrylic acid | 0.099 g |
| Lithium acrylate | 1.250 g |
| Water | 0.900 g |
| Poly-N-vinyl pyrrolidone (30% solids) | 1.875 g |
| Methylene blue solution (6.40 g methylene blue in water to make 1000 ml) | 0.684 g |
| Methylene bisacrylamide solution (0.040 g methylene bisacrylamide, 0.400 g 2-propanol and .560 g water | 0.245 g |
| Corcat P-600 solution (4.26 g water, 0.943 g Corcat P-600 branched polyethylenemine, 0.0078 g p-methoxyphenol, and 0.039 g 2-propanol) | 1.875 g |

This coating mix was spin coated onto glass slides to a dry thickness of about 5 micrometer to provide a series of coated slides which were exposed to a He:Ne laser (total intensity 10 $mw/cm^2$) as in Example 2 for 1, 2, 3, 5, 7 and 10 seconds each. After the laset exposure, each exposed slide was fixed by flood exposure, and then washed for one minute in an alcoholic solution of 5 % zirconium acetate at about 48° C. The slide then was rinsed in a beaker of 38° C. 2-propanol, followed by a squeeze-bottle applied rinse of room temperature 2-propanol, after which it was held for two minutes over boiling 2-propanol. The reconstructed object beam data was as follows:

| Exposure Time (seconds) | Diffraction Efficiency |
|---|---|
| 1 | 46 % |
| 2 | 60 % |
| 3 | 60 % |
| 5 | 60 % |
| 7 | 64 % |
| 10 | 58 % |

The Airy disk obtained in the 1, 2, 3 and 10 second exposures was of very good quality.

As noted above, the branched polyethylenimine is effective in photopolymerization systems in which the photopolymerizable solution or fluid is contained between spaced apart glass slides. The following examples illustrate this use.

**Example 5**

A solution of acrylic acid, Corcat P-600 branched polyethylenimine, sodium riboflavin-5-phosphate and tetraethylene glycol dimethacrylate between glass plates was exposed to two overlapping laser beams using an argon ion laser (488 nm). The resulting grating image had a resolution of 2500 lines/mm.

**Example 6**

A solution of lithium acrylate, Corcat P-600 branched polyethylenimine, N,N'-methylene bisacrylamide and methylene blue between glass plates was exposed to two overlapping laser beams using a He:Ne laser (633 nm) to make a holographic grating image.

As noted above, derivatized polyethylenimines may be used as the branched polyethylenimine. Dow PEI 600E hydroxyethylated polyethylenimine (prepared by reaction of ethylene oxide and branched polyethylenimine was less effective than Corcat P-600, and tended to give cloudy coatings. Lower molecular weight versions of Corcat P-600 branched polyethylenimine, e.g., Corcat P-100 mol. wt. 10-20,000, Corcat P-18 mol. wt, 1800 and Corcat P-12 mol. wt. 1200 all were effective but not as effective as Corcat P-600, whereas higher molecular weight Corcat P-2500 mol. wt. 250,000 gave an undesirably viscous mixture difficult to coat.

When triethanolamine was used in place of Corcat P-600 branched polyethylenimine with lithium acrylate, the resulting coating had weak sensitivity and the processed coating was very white. Weak sensitivity also was observed when triethanol amine was used in a solution containing lithium acrylate.

The following experiments compare linear polyethylenimine with branched polyethylenimine as a photopolymerization initiator:

**Comparison Example A**

Poly-(2-ethyl-2-oxazoline) was 59 % hydrolyzed to give a linear polyethylenimine in which 41 % of the nitrogens were substituted by

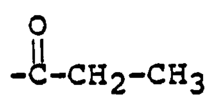

(amide groups). (This polymer is hereinafter referred to as "59 % hydrolyzed PEO".) A premix aqueous solution was prepared by mixing 3.42 g of a 27.6 % aqueous solution of said 59 % hydrolyzed PEO, 2.34 g of water and 0.05 g of a 2 % solution of p-methoxyphenol in 2-propanol, and the pH of this solution was adjusted to about 10 by addition of 15 drops of 16.7 % aqueous NaoH. 0.544 g of this premix solution was mixed with 0.25 g of acrylic acid, 0.279 g of lithium acrylate, 0.05 g of a methylene bisacrylamide solution (0.04 g methylene bisacrylamide, 0.4 g of 2-propanol and 0.56 g of water), 0.15 g of a 50 % aqueous solution of triphenylsulfonium chloride and 0.1 g of methylene blue solution (3.2 g of methylene blue in water to make 1000 ml). The resulting coating solution was fluid and very clear. A few drops of this coating solution was placed between glass slides to form a sandwich. Exposure of this sandwich to an Itek test target using red-filtered light from a Polaroid slide projector for 90 seconds did not give a visible image; a subsequent 3 minute white light flood exposure made the coating cloudy and a weak blurry image in the cloudy coating. Laser exposures of 8, 16, 32, 60 and 90

seconds to a 6 mm spot from a He:Ne laser (633 nm) gave no sign of an image. No bleaching of the methylene blue dye was observed in any of these exposures. This procedure was repeated using a second coating fluid made by adding to the remaining first coating fluid about half its volume of the 59 % hydrolyzed PEO premix in order to increase the linear polyethylenimine content. There was no observable effect when a sandwich of this second coating fluid between glass plates was exposed for 90 seconds to red-filtered light from the slide projector. No bleaching of the methylene blue dye was observed in this test either.

**Comparison Example B**

Poly-(2-ethyl-2-oxazoline) was 93 % hydrolyzed to give a linear polyethylenimine in which 7 % of the nitrogens were substituted by

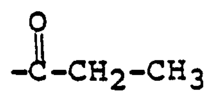

(amide groups). (This polymer is hereinafter referred to as "93 % hydrolyzed PEO".) A premix aqueous solution was prepared by mixing 3.42 g of a 38 % aqueous solution of said 93 % hydrolyzed PEO, 1.50 g of water and 0.05 g of a 2 % solution of p-methoxyphenol in 2-propanol, and the pH of this solution was adjusted to 8.0-8.5 by the addition of 16.7 % aqueous sodium hydroxide. This solution was stirred overnight to give a clear, near-orange colored solution. 0.75 g of this premix solution was mixed with 0.25 g of acrylic acid, 0.28 g of lithium acrylate, 0.05 g of a methylene bisacrylamide solution (0.04 g of methylene bisacrylamide, 0.4 g of 2-propanol and 0.56 g of water), 0.15 g of a 50 % aqueous solution of triphenylsulfonium chloride and 0.1 g of methylene blue solution (3.2 g of methylene blue in water to make 1000 ml). Laser exposures of this fluid sandwiched between glass plates gave no sign of an image after 8, 16, 32 and 60 seconds exposure to a 6 min spot from a He:Ne laser. A subsequent 3 minute white light exposure using a Polaroid slide projector made the coating slightly cloudy without an image.

In view of the fact that test coatings in the above Comparison Examples A and B were alkaline, the linear polyethylenimine also was tested under acidic conditions.

**Comparison Example C**

Test Sample A was prepared by mixing 2.0 g of acrylic acid, 0.10 g of tetraethyleneglycol dimethacrylate, 0.05 g of a 0.4 % aqueous sodium riboflavin-5-phosphate and 1.79 g of a 27.6 % aqueous solution of 59 % hydrolyzed PEO. Test Sample B was prepared in the same manner except 2.50 g of the 27.6 % aqueous solution of 59 % hydrolyzed PEO was added. Test Sample C was prepared in the same manner substituting 1.72 g of a 38 % paste of 93 % hydrolyzed PEO; the paste did not dissolve. A control Sample D was prepared in the same manner using 1.50 g of a 33 % aqueous solution of Corcat P-600 branched polyethylenimine. Each of the test samples was placed in a test tube with a thermocouple attached and exposed at room temperature to white light from a Polaroid slide projector. The temperature increase of each test sample as a function of the duration of the exposure was measured as follows:

| Test Sample | Polyethylenimine | Exposure Time | ΔT° |
|---|---|---|---|
| A | 59 % Hydrolyzed PEO | 6 min | nil |
| B | 1.4X 59 % Hydrolyzed PEO | 3 min | nil |
| C | 93 % Hydrolyzed PEO | 5 1/2 min | nil |
| D | Corcat P-600 branched | 40 seconds | >46° C. |

(A very slight temperature rise observed with Test Samples A, B and C was attributed to the warming effect of the projector light, and the ΔT° was therefore considered to be nil.) The lack of a temperature rise with the linear polyethylenimine Test Samples A, B and C showed that photopolymerization did not occur, whereas it did with the branched polyethylenimine.

In view of the above comparison examples, linear polyethylenimine is considered to be ineffective as a photopolymerization initiator, whereas the branched polyethylenimine is highly effective.

Coatings of the type prepared in Example 4 have been found to have very good shelf life. When stored dry at 3° C. and then humidified before use, such coatings were found to be useful for He:Ne laser imaging after more than 9 months dry storage, and for He:Cd laser imaging after 3 months dry storage. Such coatings have been found to give very high resolution images; reflection holograms made with He:Ne laser exposure have been made with resolution of about 4,700 lines/mm, while gratings made with He:Cd laser imaging have exhibited

resolution greatet than 3200 lines/mm.

Holograms made using the preferred embodiment of this invention include diffraction gratings made with He:Ne, Argon ion and He:Cd lasers, reflection holograms using He:Ne lasers and rainbow holograms using He:Ne lasers.

As noted above, the combination of a branched polyethylenimine, lithium acrylate and methylene blue, as exemplified by Example 4, has been found to be highly sensitive, with exposures as short as 5-10 $mJ/cm^2$ being sufficient to obtain high diffraction efficiency transmission holograms. Exposures of 30 $mJ/cm^2$ have given bright reflection holograms. Of special significance is the fact that such films exhibit very little sensitivity to oxygen and they therefore may be used in the presence of atmospheric oxygen. Refraction index modulation of 0.03 has been obtained with such films.

Humidification of coated photopolymerizable elements of the type illustrated in Example 4 may be as short as 1.5 to 2 minutes, with longer times, e.g., up to 2 hours, being acceptable. In general, the relative humidity for humidification of the dry coating preferably is about 47 to 51 % RH, although active coatings can be obtained at somewhat higher or lower relative humidities. Very low relative humidity, e.g., 33 %, and very high relative humidity, e.g., 79 %, do not activate the films. The photopolymerizable element should be exposed as soon as possible after activation by the humidification treatment. It is desirable that the moisture content of the activated coating remain substantially unchanged during the image and flood exposures.

The above described treatment of the photopolymer image with zirconium compounds has been found to be very effective in stabilizing the image against physical change, i.e., swelling or shrinking. Holographic images stabilized with zirconium acetate have been found to exhibit no significant decrease in diffraction efficiency unless subjected to very high relative humidity, e.g., about 85 % or higher, for prolonged periods of days or weeks. A particularly useful technique for effecting the zirconium acetate treatment is to immerse the imaged element in a bath of zirconium acetate, acetic acid, methanol and water for about 1 minute at room temperature with agitation. The zirconium acetate concentration may be about 5 to 20 %. The currently preferred concentrations are 10 % zirconium acetate, 4 % acetic acid, 20 % water and 66 % methanol. The methanol:water ratio may be varied to control the swelling or shrinking of the photopolymer image as may be desired, and all of the water may be replaced by methanol. The acetic acid is present to prevent hydrolysis of the zirconium acetate. The zirconium acetate-treated image is rinsed with 2-propanol at room temperature. Drying of the rinsed image is preferably effected with heat, e.g., with a heat gun or by holding in hot 2-propanol vapors for about 30-120 seconds, to avoid pick up of water when the 2-propanol is removed.

If additional resistance is desired to changes induced by high humidity, the zirconium compound treated material may be treated with a fatty acid to form a reaction product with the zirconium.

It is believed that the fatty acid reacts with the zirconium to form a product of the type referred to in the literature as a zirconium soap.

The particular acid employed does not appear to be critical, and beneficial effects have been obtained with typical fatty acids, e.g., stearic, lauric, palmitic, myristic and oleic acids. Monocarboxylic acids as short as three and four carbons have been reported to give water-insoluble zirconium compounds. While such shorter chain acids may be considered to be fatty acids for the purposes of this use since they give hydrophobic zirconium salts, it is preferred to use acids having longer alkyl chains, e.g., at least eight carbons, to obtain the extra hydrophobicity. The fatty acid preferably is employed as a solution in an organic solvent, e.g., isopropanol or xylene.

The quantity of zirconium and fatty acid incorporated in the hologram is not critical, provided that it is sufficient to be effective in increasing the stability of the hologram to humidity.

The following examples illustrate this stabilization process.

**Example 7**

A photopolymerizable composition similar to that used in Example 4 above was spin coated on to a 5 cm square glass slide cover to a dry thickness of about 5 micrometer. This slide was incubated at about 51 % R.H. to activate it prior to being imaged with a He:Ne laser to provide a transmission holographic grating. The laser-exposed slide then was given a white light flood exposure and then soaked for about a minute in a solution of 10 % zirconium acetate, 4 % acetic acid, 20 % water and 66 % methanol, rinsed in 2-propanol, and then was soaked for 5 minutes in isopropanol containing 5 % stearic acid. After rinsing in isopropanol and drying over isopropanol vapors, the hologram exhibited greatly improved water resistance and retained its image even when immersed in water. The treated hologram also had improved abrasion resistance. There was no apparent change in the optical properties of the hologram.

**Example 8**

A series of transmission holographic gratings were prepared as described in Example 7 through the step of treating with zirconium acetate and rinsing. The thus-treated slides were soaked in 5 % xylene solutions of a

fatty acid for 20 minutes at room temperature, washed in isopropanol and dried over isopropanol vapors. The diffraction efficiency of each slide was measured before and after the fatty acid treatment, and again 24 and 48 hours after the fatty acid treated slides were held at 95 % R.H. at room temperature. A control slide was given the zirconium acetate treatment but not the fatty acid treatment. The following results were obtained:

| | | % Diffraction Efficiency | | |
|---|---|---|---|---|
| Fatty Acid | Initial | After Fatty Acid | 24 h 95 % RH | 48 h 95 % RH |
| Stearic | 84 | 75 | 82 | 77 |
| Lauric | 84 | 72 | 78 | 77 |
| Palmitic | 80 | 72 | 72 | 72 |
| Myristic | 77 | 72 | 75 | 77 |
| Oleic | 77 | 69 | 75 | 77 |
| Control | 73 | - | 4 | 2 |
| Stearic plus 0.1 % Corfax 712 | 84 | 77 | 78 | 77 |

**Example 9**

Another set of transmission holographic gratings were prepared as described in Example 8. These holograms were treated for 10 minutes in boiling 5 % xylene solution of fatty acid and then allowed to cool in the fatty acid solution for 10 minutes. The following results were obtained in the same type of incubation study:

| | | % Diffraction Efficiency | | |
|---|---|---|---|---|
| Fatty Acid | Initial | After Fatty Acid | 24 h 95 % RH | 48 h 95 % RH |
| Stearic | 80 | 75 | 78 | 80 |
| Lauric | 80 | 75 | 78 | 77 |
| Palmitic | 80 | 75 | 78 | 77 |
| Myristic | 73 | 69 | 72 | 75 |
| Oleic | 80 | 75 | 82 | 77 |
| Stearic plus 0.05 % Corfax 712 | 73 | 72 | 75 | 75 |

**Example 10**

A series of reflection holograms were prepared by the procedure described in Example 2 and soaked for 20 minutes at room temperature in 5 % xylene solutions of oleic, lauric, stearic, palmitic and myristic acids. The treated holograms and an untreated control reflection hologram were incubated for 24 h at 95 % R.H.

Transmission spectra showed a shift in the transmission minimum to the blue region after 24 h, but with no further shift with time. The diffraction efficiency of the treated holograms, as inferred from the percent transmission at the minimum of each spectrum, was substantially unchanged after incubation, whereas the control hologram was almost completely destroyed.

As noted above, the novel photopolymerizable compositions of this invention are useful in forming various holographic elements. Indeed, the dye-sensitized photopolymerizable coated films containing lithium acrylate and a branched polyethylenimine have been found to be very useful in forming a holographic multiplexer/demultiplexer, e.g., of the type described in U.S. patent 4,359,259 issued November 16, 1982 to Horner et al. The holographic elements may be used as narrow band filters in laser protection optics and in head up display optics.

**Claims**

1. A photopolymerizable composition comprising an ethylenic unsaturated monomer, a dye sensitizer, and a photoinitiator, characterized in that said photoinitiator is a branched polyethyleneimine.

2. A photopolymerizable composition as defined in claim 1, characterized in that at least 20% of the

nitrogens in said branched polyethyleneimine are tertiary nitrogens.

3. A photopolymerizable composition as defined in claim 1, characterized in that said dye sensitizer is methylene blue.

4. A photopolymerizable composition as defined in claim 1, characterized in that said ethylenic unsaturated monomer is a monovalent salt of acrylic acid.

5. A photopolymerizable composition as defined in claim 1, characterized in that said ethylenic unsaturated monomer is lithium acrylate.

6. A photopolymerizable composition as defined in claim 5, characterized in that said composition further includes poly-N-vinyl pyrrolidone.

7. A photopolymerizable element comprising a support carrying a layer comprising an acrylate, a photoinitiator and a dye sensitizer characterized in that said acrylate is lithium acrylate, said photoinitiator is a branched polyethyleneimine, and said layer further includes poly-N-vinylpyrrolidone.

8. A photopolymerizable element as defined in claim 7, characterized in that at least 20% of the nitrogens in said branched polyethyleneimine are tertiary nitrogens.

9. A photopolymerizable element as defined in claim 7, characterized in that said dye sensitizer is methylene blue.

10. A photopolymerizable element as defined in claim 9, characterized in that said element includes a second dye sensitizer effective to extend the sensitivity range of said methylene blue.

11. A method of producing a photopolymerizable material which comprises coating a support with a layer comprising an acrylate, a dye sensitizer and a photoinitiator and drying said layer characterized in that said acrylate is lithium acrylate, said photoinitiator is a branched polyethyleneimine and said layer further includes poly-N-vinyl pyrrolidone, and said coated support is stored in a low humidity environment whereby said lithium acrylate layer is maintained substantially non-photopolymerizable.

12. The method of claim 11, characterized in that said method includes the step of humidifying said lithium acrylate layer to render it photosensitive.

13. The method of claim 11, characterized in that said dye sensitizer is methylene blue.

14. The method of claim 11, characterized in that at least 20% of the nitrogens in said branched polyethyleneimine are tertiary nitrogens.

15. The method of claim 14, characterized in that said branched polyethyleneimine has a molecular weight of about 60,000.

16. The method of claim 14, characterized in that said branched polyethyleneimine is hydroxyethylated polyethyleneimine.

17. The method of claim 11, characterized in that said dye sensitizer is erythrosin.

18. The method of claim 11, characterized in that said dye sensitizer is eosin Y.

19. The method of claim 11, characterized in that said dye sensitizer is sodium riboflavin-5-phosphate.

20. The method of claim 12, characterized in that said method includes the step of exposing said humidified lithium acrylate layer to radiation effective to initiate photopolymerization and form a photopolymer image in said layer.

21. The method of claim 11, characterized in that said lithium acrylate is present in a stoichiometric excess based upon the total nitrogens in the branched polyethyleneimine.

22. A method of forming a photopolymer image which comprises imagewise exposing a photopolymerizable composition comprising an ethylenic unsaturated monomer, a dye sensitizer and a photoinitiator to light absorbed by said dye sensitizer, thereby effecting imagewise photopolymerization of said monomer, characterized in that said photoinitiator is a branched polyethyleneimine.

23. The method of claim 22, characterized in that at least 20% of the nitrogens in said branched polyethyleneimine are tertiary nitrogens.

24. The method of claim 22, characterized in that said dye sensitizer is methylene blue.

25. The method of claim 22, characterized in that said dye sensitizer is sodium riboflavin-5-phosphate.

26. The method of claim 22, characterized in that said ethylenic unsaturated monomer is a monovalent salt of acrylic acid.

27. The method of claim 26, characterized in that said ethylenic unsaturated monomer is lithium acrylate.

28. The method of claim 27, characterized in that said photopolymerizable composition includes poly-N-vinylpyrrolidone.

29. The method of claim 28, characterized in that said photopolymerizable composition is a coated layer on a support.

30. The method of claim 29, characterized in that said exposure is effected by a laser.

31. The method of claim 30, characterized in that said photopolymer image is a hologram.

32. The method of claim 22, characterized in that said method includes the step of uniformly exposing said photopolymerizable composition subsequent to said imagewise exposure.

33. The method of claim 27, characterized in that said lithium acrylate is present in a stoichiometric excess based upon the total nitrogens in said branched polyethyleneimine.

34. The method of claim 22, characterized in that said method includes the step of treating said photopolymer image with a solution of a zirconium compound.

35. The method of claim 34, characterized in that said zirconium compound is zirconium acetate.

36. The method of claim 34, characterized in that said method includes the step of treating said zirconium-

treated photopolymer image with a solution of a fatty acid.

37. The method of claim 36, characterized in that said fatty acid is stearic acid.

## Patentansprüche

1. Photopolymerisierbare Zusammensetzung, enthaltend ein ethylenisch ungesättigtes Monomer, einen Farbstoff-Sensibilisator und einen Photoinitiator, dadurch gekennzeichnet, daß der Photoinitiator ein verzweigtes Polyethylenimin ist.

2. Photopolymerisierbare Zusammensetzung nach Anspruch 1, dadurch gekennzeichnet, daß mindestens 20% der Stickstoffatome in dem verzweigten Polyethylenimin tertiäre Stickstoffatome sind.

3. Photopolymerisierbare Zusammensetzung nach Anspruch 1, dadurch gekennzeichnet, daß der Farbstoff-Sensibilisator Methylenblau ist.

4. Photopolymerisierbare Zusammensetzung nach Anspruch 1, dadurch gekennzeichnet, daß das ethylenisch ungesättigte Monomer ein einwertiges Salz der Acrylsäure ist.

5. Photopolymerisierbare Zusammensetzung nach Anspruch 1, dadurch gekennzeichnet, daß das ethylenisch ungesättigte Polymer Lithiumacrylat ist.

6. Photopolymerisierbare Zusammensetzung nach Anspruch 5, dadurch gekennzeichnet, daß sie zusätzlich Poly-N-Vinylpyrrolidon enthält.

7. Photopolymerisierbares Element, enthaltend eine Unterlage, die eine Schicht enthaltend ein Acrylat, einen Photoinitiator und einen Farbstoff-Sensibilisator trägt, dadurch gekennzeichnet, daß das Acrylat Lithiumacrylat und der Photoinitiator ein verzweigtes Polyethylenimin ist und daß die Schicht zusätzlich Poly-N-Vinylpyrrolidon enthält.

8. Photopolymerisierbares Element nach Anspruch 7, dadurch gekennzeichnet, daß mindestens 20% der Stickstoffatome in dem verzweigten Polyethylenimin tertiäre Stickstoffatome sind.

9. Photopolymerisierbares Element nach Anspruch 7, dadurch gekennzeichnet, daß der Farbstoff-Sensibilisator Methylenblau ist.

10. Photopolymerisierbares Element nach Anspruch 9, dadurch gekennzeichnet, daß es einen zweiten Farbstoff-Sensibilisator enthält, der dahingehend wirkt, daß der Empfindlichkeitsbereich des Methylenblaus ausgedehnt wird.

11. Verfahren zur Herstellung eines photopolymerisierbaren Materials, nach welchem eine Unterlage mit einer Schicht, enthaltend ein Acrylat, einen Farbstoff-Sensibilisator und einen Photoinitiator, überzogen und diese Schicht getrocknet wird, dadurch gekennzeichnet, daß das Acrylat Lithiumacrylat und der Photoinitiator ein verzweigtes Polyethylenimin ist und daß die Schicht zusätzlich Poly-N-Vinylpyrrolidon enthält und daß die beschichtete Unterlage in einer Umgebung mit niedriger Feuchtigkeit gelagert wird, wodurch die Lithiumacrylatschicht im wesentlichen nicht-photopolymerisierbar gehalten wird.

12. Verfahren nach Anspruch 11, dadurch gekennzeichnet, daß die Lithiumacrylatschicht angefeuchtet wird, um sie lichtempfindlich zu machen.

13. Verfahren nach Anspruch 11, dadurch gekennzeichnet, daß der Farbstoff-Sensibilisator Methylenblau ist.

14. Verfahren nach Anspruch 11, dadurch gekennzeichnet, daß mindestens 20% der Stickstoffatome im verzweigten Polyethylenimin tertiäre Stickstoffatome sind.

15. Verfahren nach Anspruch 14, dadurch gekennzeichnet, daß das verweigte Polyethylenimin ein Molekulargewicht von etwa 60.000 hat.

16. Verfahren nach Anspruch 14, dadurch gekennzeichnet, daß das verzweigte Polyethylenimin hydroxyethyliertes Polyethylenimin ist.

17. Verfahren nach Anspruch 11, dadurch gekennzeichnet, daß der Farbstoff-Sensibilisator Erythrosin ist.

18. Verfahren nach Anspruch 11, dadurch gekennzeichnet, daß der Farbstoff-Sensibilisator Eosin Y ist.

19. Verfahren nach Anspruch 11, dadurch gekennzeichnet, daß der Farbstoff-Sensibilisator Natrium-Riboflavin-5-Phosphat ist.

20. Verfahren nach Anspruch 12, dadurch gekennzeichnet, daß die befeuchtete Lithiumacrylatschicht einer Strahlung ausgesetzt wird, die dahingehend wirkt, daß eine Photopolymerisation in Gang gesetzt und ein Photopolymer-Bild in der Schicht erzeugt wird.

21. Verfahren nach Anspruch 11, dadurch gekennzeichnet, daß das Lithiumacrylat in einem stöchiometrischen Überschuß, bezogen auf die gesamten Stickstoffatome im verzweigten Polyethylenimin vorliegt.

22. Verfahren zur Erzeugung eines Photopolymer-Bildes, wobei eine photopolymerisierbare Zusammensetzung, enthaltend ein ethylenisch ungesättigtes Monomer, einen Farbstoff-Sensibilisator und einen Photoinitiator bildmäßig mit Licht, das durch den Farbstoff-Sensibilisator absorbiert wird, belichtet wird, wobei eine bildmäßige Photopolymerisierung des Monomers erfolgt, dadurch gekennzeichnet daß der Photoinitiator ein verzweigtes Polyethylenimin ist.

23. Verfahren nach Anspruch 22, dadurch gekennzeichnet, daß mindestens 20 % der Stickstoffatome im verzweigten Polyethylenimin tertiäre Stickstoffatome sind.

24. Verfahren nach Anspruch 22, dadurch gekennzeichnet, daß der Farbstoff-Sensibilisator Methylenblau ist.

25. Verfahren nach Anspruch 22, dadurch gekennzeichnet, daß der Farbstoff-Sensibilisator Natrium-Riboflavin-5-Phosphat ist.

26. Verfahren nach Anspruch 22, dadurch gekennzeichnet, daß das ethylenisch ungesättigte Monomer ein einwertiges Salz der Acrylsäure ist.

27. Verfahren nach Anspruch 26, dadurch gekennzeichnet, daß das ethylenisch ungesättigte Monomer Lithiumacrylat ist.

28. Verfahren nach Anspruch 27, dadurch gekennzeichnet, daß die photopolymerisierbare Zusammensetzung Poly-N-Vinylpyrrolidon enthält.

29. Verfahren nach Anspruch 28, dadurch gekennzeichnet, daß die photopolymerisierbare Zusammensetzung eine auf eine Unterlage aufgebrachte Schicht darstellt.

30. Verfahren nach Anspruch 29, dadurch gekennzeichnet, daß die Belichtung mit Hilfe eines Lasers erfolgt.

31. Verfahren nach Anspruch 30, dadurch gekennzeichnet, daß das Photopolymer-Bild eine Hologramm darstellt.

32. Verfahren nach Anspruch 22, dadurch gekennzeichnet, daß die photopolymerisierbare Zusammensetzung nach der bildmäßigen Belichtung gleichmäßig belichtet wird.

33. Verfahren nach Anspruch 27, dadurch gekennzeichnet, daß das Lithiumacrylat in einem stöchiometrischen Überschuß, bezogen auf die Gesamt-Stickstoffatome im verzweigten Polyethylenimin vorhanden ist.

34. Verfahren nach Anspruch 22, dadurch gekennzeichnet, daß das Photopolymer-Bild mit einer Lösung einer Zirkonverbindung behandelt wird.

35. Verfahren nach Anspruch 34, dadurch gekennzeichnet, daß die Zirkonverbindung Zirkonacetat ist.

36. Verfahren nach Anspruch 34, dadurch gekennzeichnet, daß das mit Zirkon behandelt Photopolymer-Bild mit einer Lösung einer Fettsäure behandelt wird.

37. Verfahren nach Anspruch 36, dadurch gekennzeichnet, daß die Fettsäure Stearinsäure ist.

**Revendications**

1. Composition photopolymérisable comprenant un monomère à insaturation éthylénique, un colorant sensibilisateur, et un photoamorceur, caractérisée en ce que ledit photoamorceur est une polyéthylène-imine ramifiée.

2. Composition photopolymérisable telle que définie dans la revendication 1, caractérisée en ce que au moins 20 % des atomes d'azote dans ladite polyéthylène-imine ramifiée sont des atomes d'azote tertiaires.

3. Composition photopolymérisable telle que définie dans la revendication 1, caractérisée en ce que ledit colorant sensibilisateur est le bleu de méthylène.

4. Composition photopolymérisable telle que définie dans la revendication 1, caractérisée en ce que ledit monomère à insaturation éthylénique est un sel monovalent de l'acide acrylique.

5. Composition photopolymérisable telle que définie dans la revendication 1, caractérisée en ce que ledit monomère à insaturation éthylénique est l'acrylate de lithium.

6. Composition photopolymérisable telle que définie dans la revendication 5, caractérisée en ce que ladite composition contient en outre une poly(N-vinylpyrrolidone).

7. Elément photopolymérisable comprenant un support portant une couche comprenant un acrylate, un photoamorceur, et un colorant sensibilisateur, caractérisé en ce que ledit acrylate est l'acrylate de lithium, ledit photoamorceur est une polyéthylène-imine ramifiée, et ladite couche comprend en outre une poly(N-vinylpyrrolidone).

8. Elément photopolymérisable tel que défini dans la revendication 7, caractérisé en ce qu'au moins 20 % des atomes d'azote dans ladite polyéthylène-imine ramifiée sont des atomes d'azote tertiaires.

9. Elément photopolymérisable tel que défini dans la revendication 7, caractérisé en ce que ledit colorant sensibilisateur est le bleu de méthylène.

10. Elément photopolymérisable tel que défini dans la revendication 9, caractérisé en ce que ledit élément comprend un second colorant sensibilisateur, ce qui a pour effet d'étendre le domaine de sensibilité dudit bleu de méthylène.

11. Procédé de production d'un matériau photopolymérisable, qui comprend l'enduction d'un support avec une couche comprenant un acrylate, un colorant sensibilisateur et un photoamorceur, et le séchage de ladite couche, caractérisé en ce que ledit acrylate est l'acrylate de lithium, ledit photoamorceur est une polyéthylène-imine ramifiée, et ladite couche comprend en outre une poly(N-vinylpyrrolidone), et ledit support enduit est emmagasiné dans un environnement à faible humidité, grâce à quoi ladite couche d'acrylate de lithium est maintenue dans un état pratiquement non photopolymérisable.

12. Procédé de la revendication 11, caractérisé en ce que ledit procédé comprend une étape où l'on humidifie ladite couche d'acrylate de lithium afin de la rendre photosensible.

13. Procédé de la revendication 11, caractérisé en ce que ledit colorant sensibilisateur est le bleu de méthylène.

14. Procédé de la revendication 11, caractérisé en ce qu'au moins 20 % des atomes d'azote dans ladite polyéthylène-imine ramifiée sont des atomes d'azote tertiaires.

15. Procédé de la revendication 14, caractérisé en ce que ladite polyéthylène-imine ramifiée possède une

masse moléculaire d'environ 60.000.

16. Procédé de la revendication 14, caractérisé en ce que ladite polyéthylène-imine ramifiée est une polyéthylène-imine hydroxyéthylée.

17. Procédé de la revendication 11, caractérisé en ce que ladite colorant sensibilisateur est l'érythrosine.

18. Procédé de la revendication 11, caractérisé en ce que ledit colorant sensibilisateur est l'éosine Y.

19. Procédé de la revendication 11, caractérisé en ce que ledit colorant sensibilisateur est le riboflavine-5-phosphate de sodium.

20. Procédé de la revendication 12, caractérisé en ce que ledit procédé comprend une étape où l'on expose ladite couche d'acrylate de lithium humidifiée à une radiation qui a pour effet d'amorcer la photopolymérisation et de former dans ladite couche une image en photopolymére.

21. Procédé de la revendication 11, caractérisé en ce que ledit acrylate de lithium est présent en excès stoechiométrique par rapport au nombre total d'atomes d'azote dans la polyéthylène-imine ramifiée.

22. Procédé de formation d'une image en photopolymère, qui comprend l'exposition selon l'image d'une composition photopolymérisable, comprenant un monomère à insaturation éthylénique, un colorant sensibilisateur et un photoamorceur, à de la lumière absorbée par ledit colorant sensibilisateur, ce qui a pour effet une photopolymérisation selon l'image dudit monomère, caractérisé en ce que ledit photoamorceur est une polyéthylène-imine ramifiée.

23. Procédé de la revendication 22, caractérisé en ce qu'au moins 20 % des atomes d'azote dans ladite polyéthylène-imine ramifiée sont des atomes d'azote tertiaires.

24. Procédé de la revendfcation 22, caractérisé en ce que ledit colorant sensibilisateur est le bleu de méthylène.

25. Procédé de la revendication 22, caractérisé en ce que ledit colorant sensibilisateur est le riboflavine-5-phosphate de sodium.

26. Procédé de la revendication 22, caractérisé en ce que ledit monomère à insaturation éthylénique est un sel monovalent de l'acide acrylique.

27. Procédé de la revendication 26, caractérisé en ce que ledit monomère à insaturation éthylénique est l'acrylate de lithium.

28. Procédé de la revendication 27, caractérisé en ce que ladite composition photopolymérisable comprend une poly(N-vinylpyrrolidone).

29. Procédé de la revendication 28, caractérisé en ce que ladite composition photopolymérisable est une couche étalée sur un support.

30. Procédé de la revendication 29, caractérisé en ce que ladite exposition est effectuée grâce à un laser.

31. Procédé de la revendication 30, caractérisé en ce que ladite image en photopolymère est un hologramme.

32. Procédé de la revendication 22, caractérisé en ce que ledit procédé comprend une étape d'exposition uniforme de ladite composition photopolymérisable, à la suite de ladite exposition selon l'image.

33. Procédé de la revendication 27, caractérisé en ce que ledit acrylate de lithium est présent en excès stoethiométrique par rapport au nombre total d'atomes d'azote dans ladite polyéthylène-imine ramifiée.

34. Procédé de la revendication 22, caractérisé en ce que ledit procédé comprend une étape de traitement de ladite image en photopolymère avec une solution d'un composé du zirconium.

35. Procédé de la revendication 34, caractérisé en ce que ledit composé du zirconium est l'acétate de zirconium.

36. Procédé de la revendication 34, caractérisé en ce que ledit procédé comprend une étape de traitement de ladite image en photopolymère, traitée au zirconium, avec une solution d'un acide gras.

37. Procédé de la revendication 36, caractérisé en ce que ledit acide gras est l'acide stéarique.